# EUROPEAN PATENT APPLICATION

(11) **EP 4 589 634 A1**
(43) Date of publication of application: **23.07.2025**
(21) Application number: 24866934.3
(22) Date of filing: 07.06.2024

(54) **PHOTOVOLTAIC MODULE AND PHOTOVOLTAIC DEVICE**

(30) Priority: 19.09.2023 CN 202322540222 U
(71) Applicant: Huansheng New Energy (Jiangsu) Co., Ltd., Yixing Wuxi, Jiangsu 214203 (CN)
(72) Inventor: MU, Chengwei, Wuxi, Jiangsu 214203 (CN); YANG, Qing, Wuxi, Jiangsu 214203 (CN); WANG, Peng, Wuxi, Jiangsu 214203 (CN); CHEN, Liangshui, Wuxi, Jiangsu 214203 (CN); WANG, Yan, Wuxi, Jiangsu 214203 (CN)
(74) Representative: Cristinelli, Luca
(86) International application number: PCT/CN2024/098143
(87) International publication number: WO 2025/060514

(57) **Abstract**

Provided are a photovoltaic module and a photovoltaic device, wherein the photovoltaic module (1000) includes: an interconnector (200), a busbar ribbon (300), and a plurality of solar cell strings (400), wherein the solar cell strings (400) include the plurality of solar cell slices (100) sequentially arranged, and two adjacent solar cell slices (100) are connected by the interconnector (200); and the plurality of power generation units (500) are formed in the photovoltaic module (1000); the busbar ribbon (300) is arranged on the back side of the photovoltaic module (1000); and the plurality of power generation units (500) are connected in series by electrical connection between the busbar ribbon (300) and the interconnector (200). It solves problems of the cost, efficiency, and process limitation because the back side of the solar cell is required to directly connect to the busbar ribbon; and at the same time, the busbar ribbon is arranged on the back side of the photovoltaic module, which solves the problem of low efficiency due to the soldering of the busbar ribbon and the interconnector in the half-cell module, thereby improving the efficiency of the module, reducing the costs, broadening the process flow, and improving the user experience.

## Description

### CROSS-REFERENCE TO RELATED APPLICATION

The present invention claims priority to Chinese patent application No. 202322540222. X, filed with the Chinese Patent Office on September 19, 2023, entitled "PHOTOVOLTAIC MODULE AND PHOTOVOLTAIC DEVICE", the entire contents of which are incorporated herein by reference.

### TECHNICAL FIELD

The present invention relates to the photovoltaic technical field, and specifically to a photovoltaic module and a photovoltaic device.

### BACKGROUND ART

Solar energy belongs to a clean energy source, and the working principle of the photovoltaic module is to convert solar energy into electric energy directly. With continuous demands for high-power modules in the industry, the shingled module technology has received widespread attention due to its unique design and high efficiency, and front-line photovoltaic module manufacturers are continuously developing new circuit designs for the shingled module.

Currently, the 6-string shingled module product uses a fully parallel design for its solar cell strings, and this design has limitations on slice (a single solar cell is cut into several small sheets, which are the slices) of the solar cell. Specifically, if the number of slices of the solar cell is large, the overlap area between the solar cell slices in the corresponding module is large; and accordingly, the utilization rate of the solar cell is low. If the number of slices of the solar cell is small, the output current of the module is large (which can be more than 21A), but it will increase the current transmission loss and the current-carrying pressure on the other components of the photovoltaic module. Additionally, in the electrical connection design of the bypass diode in the prior shingled modules, the bypass diode is usually soldered to a separately designed solder pad on the back side of the solar cell by a corresponding busbar ribbon. This connection design method has more defects as follows. The process window is narrow, and it needs to add the solder paste, flux, or other auxiliary soldering materials; since the solder pad on the back side of the solar cell is soldered to the busbar ribbon, the silver paste is needed to use to ensure the soldering effect, and the demand amount for the silver on the back side of a single solar cell is very large; the overlap of the back side is increased, and the efficiency of the solar cell is reduced; and since the busbar ribbon and the solar cell are soldered directly, it will result in the increase in the probability of internal cracks of the solar cell.

Furthermore, in the current traditional half-cell module, the bypass diode design is generally realized by directly soldering the corresponding busbar ribbon and the interconnector of the bypass diode. The interconnector extends beyond the solar cell and overlaps with the busbar ribbon, and a blank area of 10mm~20mm is usually required to be left in the middle of the module, so that the busbar ribbon is soldered to the interconnector; and at the same time, the busbar ribbon is soldered to the interconnectors at two sides, and the solar cell string at the end of the module is required to be misplaced by about 0.5mm, so that the appearance and the efficiency of the module are affected.

### SUMMARY

In view of this, an objective of the present invention is to provide a photovoltaic module and a photovoltaic device, wherein one solar cell is cut into three slices to connect three diodes in parallel, and a busbar ribbon at the corresponding position is arranged to indirectly connect to the back side of the solar cell by an interconnector, which solves problems of the cost, efficiency, and process limitation because the back side of the solar cell is required to directly connect to the busbar ribbon. Meanwhile, through the optimization of the circuit structure, it further solves the problem of low efficiency of the corresponding module since the extra space is needed for the soldering of the busbar ribbon and the interconnector in the half-cell module, so as to improve the efficiency of the module and reduce the costs, and to broaden the process flow and improve the user experience.

In a first aspect, the embodiments of the present invention provide a photovoltaic module, wherein the photovoltaic module includes: an interconnector, a busbar ribbon, and a plurality of solar cell strings, wherein the solar cell strings include a plurality of solar cell slices sequentially arranged, and two adjacent solar cell slices are connected by the interconnector; and a plurality of power generation units are formed in the photovoltaic module; the busbar ribbon is arranged on a back side of the photovoltaic module; and the plurality of power generation units are connected in series by electrical connection between the busbar ribbon and the interconnector.

In some preferred embodiments of the present invention, the busbar ribbon is a first busbar ribbon; the photovoltaic module further includes a first diode; the photovoltaic module is provided with three power generation units, including a first power generation unit, a second power generation unit, and a third power generation unit respectively, wherein the first diode is connected in parallel to the first power generation unit by the first busbar ribbon.

In some preferred embodiments of the present invention, the photovoltaic module further includes a second busbar ribbon and a second diode, wherein the second busbar ribbon is arranged on the back side of the photovoltaic module and is connected to the first busbar ribbon, and the second diode is connected in parallel to the second power generation unit by the second busbar ribbon.

In some preferred embodiments of the present invention, the photovoltaic module further includes a third busbar ribbon and a third diode, wherein the third busbar ribbon is arranged on the back side of the photovoltaic module and is connected to the first busbar ribbon, and the third diode is connected in parallel to the third power generation unit by the third busbar ribbon.

In some preferred embodiments of the present invention, at least one first solder pad is arranged between the interconnector and the solar cell slice, and the first solder pad connects to the interconnector and the solar cell slice, respectively; and at least one second solder pad is arranged between the interconnector and the busbar ribbon, and the second solder pad connects to the interconnector and the busbar ribbon respectively.

In some preferred embodiments of the present invention, the first solder pad forms a first projection on the interconnector; the busbar ribbon forms a second projection on the interconnector; and the first projection and the second projection are staggered.

In some preferred embodiments of the present invention, the number of second solder pads is 4~20.

In some preferred embodiments of the present invention, the solar cell slice is formed by cutting a 182mm silicon wafer into two or three slices; or the solar cell slice is formed by cutting a 210mm silicon wafer into two or three slices.

In some preferred embodiments of the present invention, a thickness of the busbar ribbon is 0.05 mm~0.15 mm.

In some preferred embodiments of the present invention, the thickness of the busbar ribbon is 0.08 mm~0.12 mm.

In some preferred embodiments of the present invention, a width of the busbar ribbon is 5 mm~15 mm.

In some preferred embodiments of the present invention, the width of the busbar ribbon is 8 mm~12 mm.

In some preferred embodiments of the present invention, the interconnector is a round wire solder ribbon, and a diameter of the interconnector is 0.15~0.3 mm.

In some preferred embodiments of the present invention, the busbar ribbon and/or interconnector includes a base-material layer located inside and a tin-coated layer coated on a surface of the base-material layer, and a thickness of the tin-coated layer is 10~30 µm.

In a second aspect, the embodiments of the present invention provide a photovoltaic device, including the photovoltaic module in any one of the above.

The embodiments of the present invention include the following beneficial effects.

The embodiments of the present invention provide a photovoltaic module, wherein the photovoltaic module includes: the interconnector, the busbar ribbon, and the plurality of solar cell strings, wherein the solar cell strings include the plurality of solar cell slices sequentially arranged, and two adjacent solar cell slices are connected by the interconnector; and the plurality of power generation units are formed in the photovoltaic module; the busbar ribbon is arranged on the back side of the photovoltaic module; and the plurality of power generation units are connected in series by electrical connection between the busbar ribbon and the interconnector. It solves problems of the cost, efficiency, and process limitation because the back side of the solar cell is required to directly connect to the busbar ribbon; and at the same time, it further solves the problem of low efficiency since the extra space is needed for the soldering of the busbar ribbon and the interconnector in the half-cell module, which improves the efficiency of the module, reduces the costs, broadens the process flow, and improves the user experience.

### BRIEF DESCRIPTION OF DRAWINGS

In order to more clearly illustrate the technical solutions in the specific embodiments or prior art of the present invention, the drawings to be used in the description of the specific embodiments or prior art will be briefly introduced below. It is obvious that the drawings in the following description are some embodiments of the present invention, and for persons of ordinary skill in the art, other drawings can be obtained based on these drawings without inventive efforts.
FIG. 1 shows a schematic diagram of a 6-string fully-parallel circuit in the prior art;
FIG. 2 shows a schematic diagram of soldering of a busbar ribbon of a shingled module to a solder pad on the back side in the prior art;
FIG. 3 shows a design schematic diagram of a conventional half-cell module circuit and bypass diode in the prior art;
FIG. 4 shows a schematic diagram of a circuit connection of one photovoltaic module provided by the embodiments of the present invention;
FIG. 5 shows a schematic diagram of a circuit connection of another photovoltaic module provided by the embodiments of the present invention;
FIG. 6 shows a schematic diagram of a circuit connection of another photovoltaic module provided by the embodiments of the present invention;
FIG. 7 shows a schematic diagram of a position of a first solder pad on a back side of a solar cell slice provided by the embodiment of the present invention;
FIG. 8 shows a schematic diagram of a position of a second solder pad for connecting an interconnector to a busbar ribbon provided by the embodiment of the present invention;
FIG. 9 shows a schematic structure diagram of a photovoltaic device provided by the embodiments of the present invention; and
FIG. 10 shows a local schematic structure diagram of a photovoltaic device provided by the embodiments of the present invention.

Reference numbers: 100-solar cell slice; 110-first solder pad; 120-second solder pad; 130-solder pad on the back side of the solar cell slice; 200-interconnector; 300-busbar ribbon; 310-first busbar ribbon; 320-second busbar ribbon; 330-third busbar ribbon; 400-solar cell string; 500-power generation unit; 510-first power generation unit; 520-second power generation unit; 530-third power generation unit; 610-first diode; 620-second diode; 630-third diode; 1000-photovoltaic module; and 2000-photovoltaic device.

### DETAILED DESCRIPTION OF EMBODIMENTS

In order to make the purpose, technical solutions, and advantages of the embodiments of the present invention clearer, the technical solutions in the embodiments of the present invention will be clearly and completely described in conjunction with the drawings in the embodiments of the present invention. It is clear that the embodiments described are partial embodiments of the present invention, but not all of the embodiments. The components in the embodiments of the present invention generally described and shown in the drawings herein can be arranged and designed in multiple different configurations.

Therefore, the following detailed description of embodiments of the present invention provided in the drawings is not intended to limit the scope of the present invention for which protection is claimed, but rather represents only selected embodiments of the present invention. Based on the embodiments of the present invention, all other embodiments obtained by a person of ordinary skill in the art without inventive efforts, shall fall within the scope of protection of the present invention.

It should be noted that similar symbols and letters denote similar items in the following drawings, so that once an item is defined in a drawing, no further definition or explanation is required in the subsequent drawings.

In the description of the present invention, it should be noted that the orientation or position relationship indicated by the terms "center", "up", "down", "left", "right", "vertical", "horizontal", "inside", "outside", etc., is the orientation or position relationship based on the drawings, or is the orientation or position relationship of the product of the present invention customarily placed in use, which are only to facilitate the description of the present invention and simplify the description, and are not to indicate or imply that the device or element referred to must have a particular orientation, or be constructed and operated with a particular orientation, and therefore cannot to be understood as limitations of the present invention. Furthermore, the terms "first", "second", "third", etc., are used only to differentiate the description, and are not to be understood as indicating or implying relative importance.

Additionally, the terms "horizontal", "vertical", "overhanging", etc., do not mean that the component must be absolutely horizontal or overhanging, but can be slightly inclined, e.g., "horizontal" only refers that it is more horizontal than "vertical", and does not mean that the structure must be absolutely horizontal, but can be slightly inclined.

In the description of the present invention, it should also be noted that unless other expressly specifications and limitations, the terms "arrange", "mount", "connect", and "link" are to be understood in a broad sense, e.g. it may be a fixed connection, a detachable connection, or an integral connection; it can be a mechanical connection or an electrical connection; and it can be a direct connection, an indirect connection through an intermediate medium, or a communication inside two elements. For a person of ordinary skill in the art, the specific meaning of the above terms in the present invention can be understood according to specific situations.

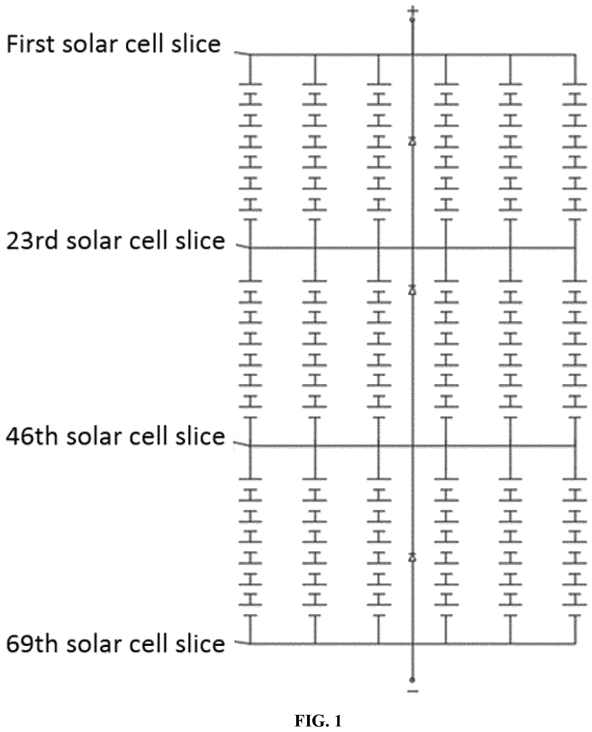

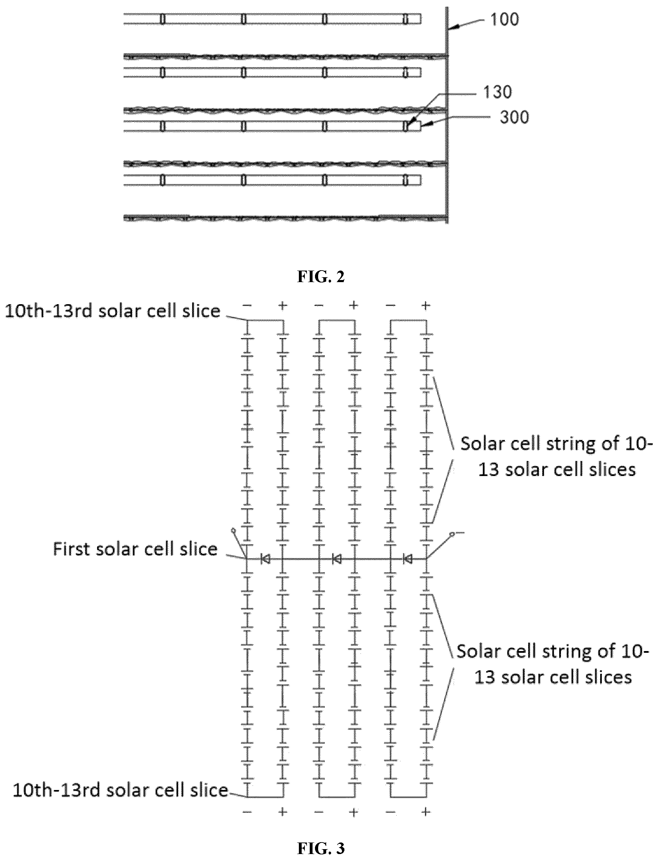

The current conventional shingled module adopts a fully parallel design, wherein the current flowing through a single solar cell string is small and is 1/5 to 1/6 of the total current of the entire solar cell; and the heat generation is low under conditions such as heat spots. FIG. 1 shows a schematic diagram of a 6-string fully-parallel circuit in the prior art, wherein the conventional shingled module uses three bypass diodes in parallel in the circuit, and the three bypass diodes are respectively connected in parallel between the first and 23rd slices, between the 23rd slice and 46th slice, and between 46th slice and 69th slice. FIG. 2 shows a schematic diagram of soldering of the busbar ribbon 300 of a shingled module to the solder pad 130 on the back side in the prior art. In the electric design of the bypass diode of the shingled module, the bypass diode is generally realized by directly soldering to the solder pad 130 on the back side of the solar cell slice 100 by the corresponding busbar ribbon 300.

Further, FIG. 3 shows a design schematic diagram of a conventional half-cell module circuit and the bypass diode in the prior art. In the conventional half-cell module, three bypass diodes are connected in parallel in the circuit by the parallel design of solar cell strings. In the electrical design of the bypass diode, the bypass diode design is realized by directly soldering the corresponding busbar ribbon and the interconnector of the bypass diode, wherein the interconnector usually extends beyond the solar cell and overlaps with the busbar ribbon. Moreover, a blank area of 10mm~20mm is usually required to be left in the middle of the module, so that the busbar ribbon is connected to the interconnector; and at the same time, the busbar ribbon is soldered to the interconnectors at two sides, and the solar cell string at the end of the module is required to be misplaced by 0.5mm, so that the appearance and the efficiency of the module are affected.

The objective of the present invention is to provide a photovoltaic module and a photovoltaic device, wherein the plurality of power generation units are connected in series by electrical connection between the busbar ribbon and the interconnector. Specifically, the interconnector is directly soldered to the back side of the corresponding solar cell by the solder pad, and the busbar ribbon is arranged on the back side of the photovoltaic module and directly soldered to the interconnector, i.e., the busbar ribbon is indirectly connected to the back side of the solar cell by the interconnector. Further, in the electric design of the bypass diode of the photovoltaic module, each bypass diode is connected in parallel to the corresponding power generation unit by the corresponding busbar ribbon. It solves problems of the cost, efficiency, and process limitation because the back side of the solar cell is required to directly connect to the busbar ribbon by providing the solder pad individually; and at the same time, it further solves the problem of low efficiency due to the soldering of the busbar ribbon and the interconnector in the half-cell module, which improves the efficiency of the module, reduces the costs, broadens the process flow, and improves the user experience.

Some embodiments of the present invention are described in detail below in conjunction with the drawings. The following embodiments and features in the embodiments can be combined with each other without conflict.

### Embodiment 1

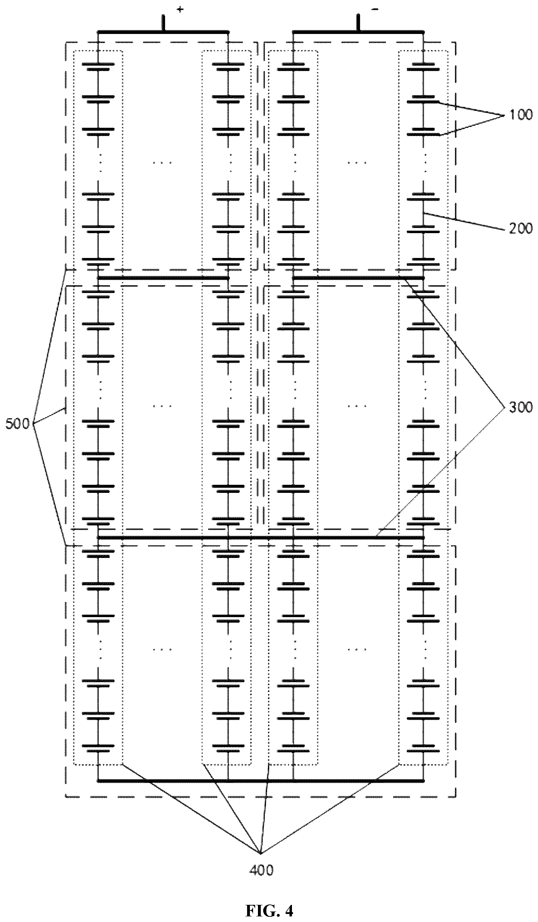

The embodiment of the present invention provides a photovoltaic module, especially for the photovoltaic module with a larger number of single solar cell strings 400. FIG. 4 shows a schematic diagram of a circuit connection of one photovoltaic module provided by the embodiment of the present invention. The photovoltaic module 1000 includes: an interconnector 200, a busbar ribbon 300, and a plurality of solar cell strings 400, wherein the solar cell strings 400 include a plurality of solar cell slices 100 sequentially arranged, and two adjacent solar cell slices 100 are connected by the interconnector 200; and a plurality of power generation units 500 are formed in the photovoltaic module 1000; the busbar ribbon 300 is arranged on the back side of the photovoltaic module 1000; and the plurality of power generation units 500 are connected in series by electrical connection between the busbar ribbon 300 and the interconnector 200.

Specifically, the photovoltaic module 1000 includes the plurality of solar cell strings 400, wherein the number of solar cell slices 100 in each solar cell string 400 is equal, and adjacent solar cell slices 100 are interconnected by the interconnector 200. In each solar cell string 400, the adjacent solar cell slices 100 can be distributed in the form of overlapping (i.e., the edge regions of the adjacent solar cell slices 100 are overlapped), or in the form of spacing (i.e., there is no overlapping part between the adjacent solar cell slices 100). In the structure design, the solar cell slice 100 in the photovoltaic module 1000 is divided into a plurality of regions by the busbar ribbon 300, and each region is a power generation unit 500 respectively. Generally, the number of solar cell slices 100 in each power generation unit 500 is also equal, which ensures that the voltage output of each power generation unit 500 is equal. The busbar ribbon 300 not only plays a role of separating the power generation unit 500, but also communicates with the plurality of power generation units 500, wherein the busbar ribbon 300 connects to the plurality of power generation units 500 in series in fact.

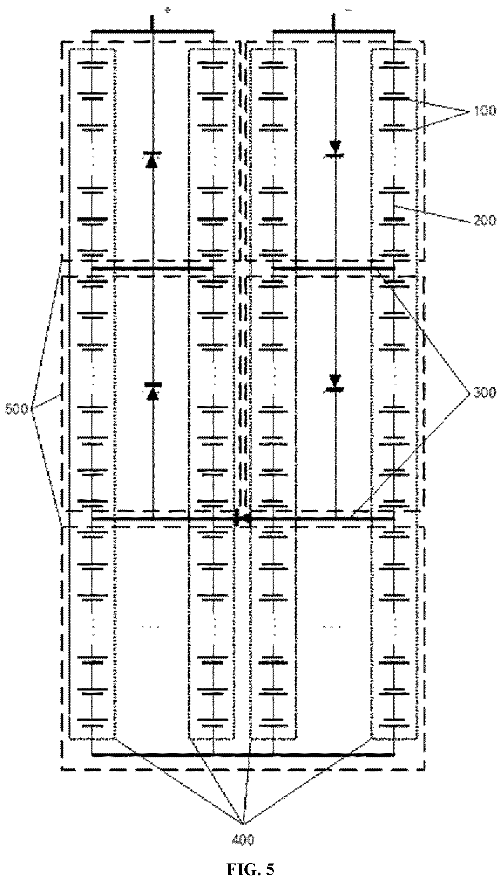

Further, a bypass diode is also connected in parallel in the photovoltaic module 1000, and specifically, the bypass diode can be electrically connected to the busbar ribbon 300, so that the bypass diode is connected in parallel to the corresponding power generation unit 500. Referring to FIG. 5, along the extension direction of the solar cell string 400, the single solar cell string 400 is divided into three regions according to the number of solar cells 2:2:1 and divided into three different power generation units 500 (it is to be noted that the number of solar cells in each region is not limited, and can be adaptively adjusted according to the actual needs). In the bottom power generation unit 500, two sections of the solar cell strings 400 are connected in series, which corresponds to the number of solar cells in each power generation unit 500 is the same, so that the entire power generation module is divided into five power generation units 500 sequentially in series, wherein each power generation unit 500 is connected to the bypass diode by the busbar ribbon 300, so that the bypass diode is connected in parallel to the corresponding power generation unit 500. It should be noted that except for the busbar ribbon 300 at the bottom bypass diode which is connected to the back side of the solar cell slice 100 by the interconnector 200 (since it is equipotential at this position, it is not necessary to provide the insulating tape), the busbar ribbons 300 at the remaining four bypass diodes are connected to the back side of the solar cell slice 100 by the insulating tape. Further, the busbar ribbon 300 used for connecting the bypass diode is formed by splicing two sections of the disconnected busbar units together, wherein the bypass diode is located between two sections of the busbar units and connects to them.

The embodiment of the present provides the solar cell component with the above specific structure. In a first aspect, the connection and design method of the conventional shingled module (its busbar ribbon 300 is generally connected to the back side of the solar cell directly by the solder pad individually provided) at present has more defects as below. The process window is narrow, and it needs to add the solder paste, flux, or other auxiliary soldering materials; since the solder pad on the back side of the solar cell is soldered to the busbar ribbon, the silver paste is needed to use to ensure the soldering effect, and the demand for the silver on the back side of a single solar cell is very large; the overlap of the back side is increased, and the efficiency of the solar cell is reduced; and since the busbar ribbon and the solar cell are soldered directly, it will result in the increase in the probability of internal cracks of the solar cell. In the photovoltaic module provided by the embodiments of the present invention, since the busbar ribbon 300 is not directly connected to the back side of the solar cell slice 100, it can reduce the number of the solder pads on the back side, thus improving the efficiency of the solar cell by 0.03% ~ 0.08%, which reduces the fragmentation rate by 0.02% ~ 0.05%, broadens the process window, reduces the dosage of the solder paste, flux, or other auxiliary soldering materials, reduces the cost, and improves the user experience, Meanwhile, the amount of the silver used on the back side can be reduced by 10~20mg, and the problem of heat spots easily occurred is solved after the busbar ribbon 300 is connected to the back side of the solar cell. Secondly, the design of the bypass diode of the conventional half-cell module at present has the following features. The interconnector 200 extends beyond the solar cell and overlaps with the busbar ribbon 300, and a blank area of 10mm~20mm is usually required to be left at the middle of the module, so that the busbar ribbon 300 is connected to the interconnector 200; and at the same time, the busbar ribbon 300 is soldered to the interconnectors 200 at two sides, and the solar cell string at the end of the module is required to be misplaced by 0.5mm, so that the appearance and the efficiency of the module are affected. Through the optimization of the circuit structure, the present invention solves the problem of low efficiency of the corresponding module since the extra space is needed for the soldering of the busbar ribbon 300 and the interconnector 200 in the half-cell module, so as to improve the efficiency of the module and reduce the costs. Additionally, it can also solve the problem in the design of the interconnector 200 extending beyond the solar cell and overlapping with the busbar ribbon 300, which makes the front side of the product cleaner, and also broadens the process flow and improves the user experience.

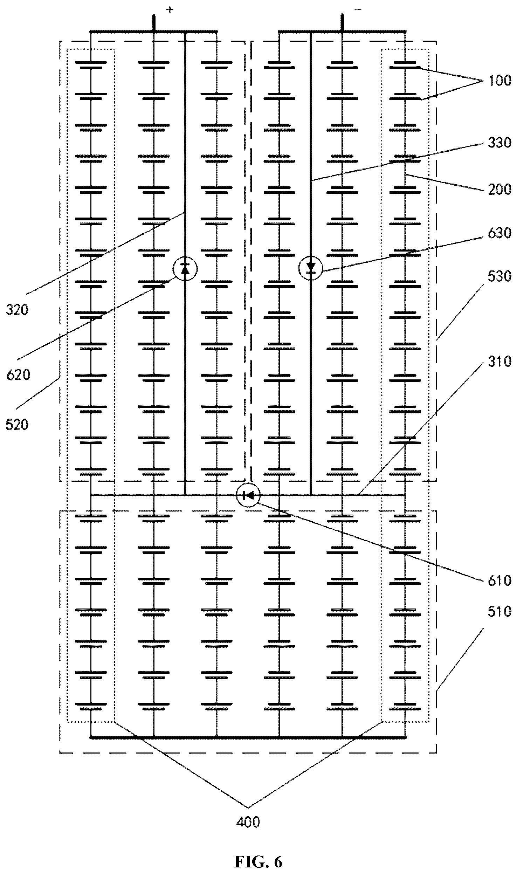

Further, for the photovoltaic module with fewer single solar cell strings 400, the number of power generation units can be reduced compared to the photovoltaic module with a larger number of solar cells of the single solar cell string 400 in FIG. 4. FIG. 6 shows a schematic diagram of a circuit connection of another photovoltaic module provided by the embodiment of the present invention. The busbar ribbon is a first busbar ribbon 310; the photovoltaic module 1000 further includes a first diode 610; the photovoltaic module 1000 is provided with three power generation units, including a first power generation unit 510, a second power generation unit 520, and a third power generation unit 530 respectively, which is equivalent to reduce two power generation units based on FIG. 4, wherein the first diode 610 is connected in parallel to the first power generation unit 510 by the first busbar ribbon 310. The first busbar ribbon 310 is formed by splicing two sections of busbar units distributed at intervals; the first diode 610 is located between the two sections of busbar units and communicates them; and the two sections of busbar units are both connected to the back side of the solar cell slice 100 by the interconnector 200. The photovoltaic module 1000 further includes a second busbar ribbon 320 and a second diode 620, wherein the second busbar ribbon 320 is arranged on the back side of the photovoltaic module 1000 and is connected to the first busbar ribbon 310, and the second diode 620 is connected in parallel to the second power generation unit 520 by the second busbar ribbon 320. The second busbar ribbon 320 is formed by splicing two sections of busbar units distributed at intervals; the second diode 620 is located between the two sections of busbar units and communicates them; and the two sections of busbar units are both connected in insulated manner to the back side of the solar cell slice 100 by the insulation strip. The photovoltaic module 1000 further includes a third busbar ribbon 330 and a third diode 630, wherein the third busbar ribbon 330 is arranged on the back side of the photovoltaic module 1000 and is connected to the first busbar ribbon 310, and the third diode 630 is connected in parallel to the third power generation unit 530 by the third busbar ribbon 330. The third busbar ribbon 330 is formed by splicing two sections of busbar units distributed at intervals; the third diode 630 is located between the two sections of busbar units and communicates them; and the two sections of busbar units are both connected in insulated manner to the back side of the solar cell slice 100 by the insulation strip.

Specifically, the photovoltaic module 1000 adopts a 6-string module design, wherein three solar cell strings 400 on the left side are connected in parallel; three solar cell strings 400 on the right side are connected in parallel; and then the left three solar cell strings 400 and the right three solar cell strings 400 are connected in series. Meanwhile, the bypass diode is connected in parallel to the corresponding solar cell unit by the busbar ribbon 300, so as to realize the electrical connection design for connecting the three bypass diodes in parallel. The 1st to 23rd solar cell slices 100 are connected in series to form three solar cell strings 400, and then the three strings of the solar cell strings 400 are connected in parallel to form the second power generation unit 520, which is connected to the second diode 620 in parallel, wherein the second diode 620 is arranged on the second busbar ribbon 320. Similarly, the 23rd to 45th solar cell slices 100 form a first power generation unit 510, which is connected to the first diode 610 in parallel; and the 45th to 68th solar cell slices 100 form a third power generation unit 530, which is connected to the third diode 630 in parallel, wherein the third diode 630 is arranged on a third busbar ribbon 330, and three diodes protect the corresponding power generation unit 500 respectively. The division standard of the power generation unit does not make specific requirements, wherein the number of solar cell slices 100 can be adjusted according to the actual need, and the division method in the present invention is only used as an example.

At least one first solder pad 110 is arranged between the interconnector 200 and the solar cell slice 100, and the first solder pad 110 connects to the interconnector 200 and the solar cell slice 100 respectively; and at least one second solder pad 120 is arranged between the interconnector 200 and the busbar ribbon 300, and the second solder pad 120 connects to the interconnector 200 and the busbar ribbon 300 respectively.

It is to be noted that the first solder pad 110 refers to a soldering point formed by sintering the silver paste after it is printed on the back side of the solar cell slice 100, which is used for electrically connecting to the interconnector 200. Specifically, the silver paste is printed on the back side of the solar cell slice 100 first and sintered to form a soldering point (i.e., the first solder pad 110), and then the interconnector 200 is soldered to the first solder pad 110, so that the interconnector 200 is electrically connected to the back side of the solar cell slice 100. The second solder pad 120 refers not to the soldering point formed by printing the silver paste and sintering it, but to a corresponding contact point when the body of the busbar ribbon 300 is directly soldered to the body of the interconnector 200. Specifically, the interconnector 200 is directly soldered to the busbar ribbon 300, so that the bodies of the two are directly connected, wherein the contact point of the bodies of the two is the second solder pad 120.

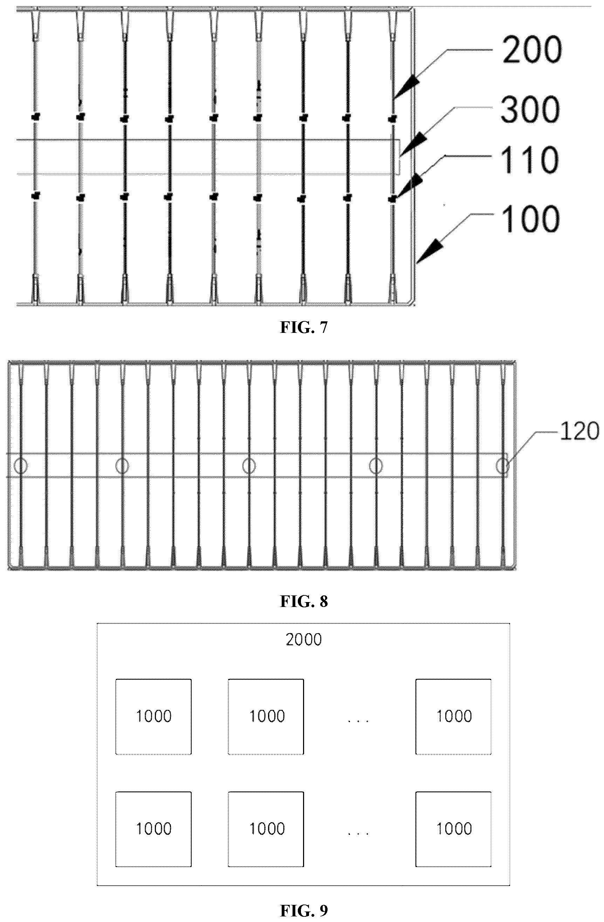

Specifically, FIG. 7 shows a schematic diagram of a position of the first solder pad 110 on the back side of the solar cell slice 100 provided by the embodiment of the present invention, wherein the solar cell slice 100 is connected to the interconnector 200 by the first solder pad 110 additionally arranged on its back side.

Further, the number of the first solder pads 110 is not limited, and can be adjusted according to the actual needs.

Further, the interconnector 200 and the busbar ribbon 300 are connected by 4 to 20 second solder pads 120. Taking 5 second solder pads 120 as an example, FIG. 8 shows a schematic diagram of a position of the second solder pad 120 for connecting the interconnector to the busbar ribbon provided by the embodiment of the present invention. The connection method between the busbar ribbon 300 and the interconnector 200 includes: soldering method, contact non-soldering method, and contact non-soldering method with external force reinforcement.

Specifically, the busbar ribbon 300 is connected to the interconnector 200 by the soldering method, contact non-soldering method, or contact non-soldering method with external force reinforcement. Soldering method: the busbar ribbon 300 is soldered to the interconnector 200 by using mainstream method, such as infrared heating, electromagnetic heating, or hot air soldering, wherein the number of soldering points is 4~20, so as to ensure the current-carrying capacity and connection intensity of the busbar ribbon 300 and the interconnector 200. Contact non-soldering method: by using a low-temperature busbar ribbon 300 or low-temperature solder ribbon 200 with a lower melting point (the alloy such as SnPbBi, and SnBiAg), the tin layer is melted and solidified by a layer-press process, and the busbar ribbon 300 and the interconnector 200 form a better physical contact after the layer press. Contact non-soldering method with external force reinforcement: in order to ensure the adhesive effect between the low-temperature busbar ribbon 300 and the interconnector 200, adhesives such as electrically conductive adhesive, insulating adhesive, thermosetting adhesive, or UV adhesive can be simultaneously used between the busbar ribbon 300 and the interconnector 200, or between the interconnector 200 and the back side of the solar cell. Different adhesives have different curing conditions, wherein the electrically conductive adhesive, insulating adhesive, and thermosetting adhesive need to be cured by heating or layer pressing, and the UV adhesive needs to be cured by UV illumination or heating.

Further, if the busbar ribbon 300 and the interconnector 200 are connected by using the contact non-soldering method, it can reduce the process pressure and improve the process window, and it can be synchronously compatible with the low-temperature slurry solar cell such as HJT (heterojunction with intrinsic thinfilm) or low-temperature process solar cell such as electroplating.

Further, the first solder pad 110 forms a first projection on the interconnector 200; the busbar ribbon 300 forms a second projection on the interconnector 200; and the first projection and the second projection are staggered.

Specifically, the connection point (i.e., the second solder pad) of the interconnector 200 and the busbar ribbon 300 does not coincide with the first solder pad 110, and the position of the busbar ribbon 300 avoids the position of the first solder pad 110, which can avoid the impact of soldering of the busbar ribbon 300 and the interconnector 200 on the back-side solder pad and the interconnector 200 of the soldered solar cell slice 100.

Further, the solar cell slice 100 is formed by cutting a 182mm silicon wafer into two or three slices, or the solar cell slice 100 is formed by cutting a 210mm silicon wafer into two or three slices, wherein the 1-cut-3 process refers to cutting a complete solar cell into three slices. The silicon wafer of a particular size is cut into a smaller number of slices, so that the area shading each other after the solar cell slices 100 overlap is smaller, so as to increase the light receiving area, thereby improving the utilization rate of the solar cell.

Specifically, the large-size silicon wafer with a solar cell specification of 182/210 is divided into three blocks by the 1-cut-to-3 design, wherein the number of the busbar is designed as 10~20BB, and it is compatible with solar cells by the process such as Perc (passivated emitter and cathode, which is a solar cell process), N-Type (which is a solar cell process), and HJT (high-temperature JET, which is a solar cell process).

Further, the number of busbars is the number of main electrode lines used to collect light energy in the solar cell. The number of busbars is usually in a range of 10~20 BB, wherein BB represents the number of busbars.

Specifically, the number of roots of the busbars determines the amount of photons that can be collected by the solar cell and the electric energy output. Generally speaking, the more the number of the busbars is, the stronger the light absorption ability of the solar cell is, so that more light energy can be collected, so as to output more electric energy. However, the number of busbars will also affect performance indicators such as manufacturing cost and weight of the solar cell. Therefore, it needs to comprehensively consider multiple factors when selecting the number of the busbars, so as to meet the needs of particular applications.

Specifically, for the Perc (passivated emitter and cathode) process solar cell: the Perc solar cell is a type of high-efficiency solar cell, whose surface is specially treated to form an oxide protective layer, which can effectively reduce the light absorption and reflection, and improve the conversion efficiency of the solar cell.

For the N-Type process solar cell: the N-Type solar cell is one of the most common types of solar cells, wherein its positive electrode is made from elements such as gallium and germanium, and its negative electrode is made from silicon. Under the illumination, the positive electrode of the N-Type solar cell releases electrons, which combine with holes on the negative electrode, so as to generate an electric current.

For the HJT (high-temperature JET) process solar cell: the HJT solar cell is a new type of high-efficiency solar cell adopting the high-temperature thermal activation technology, which can realize the charge transfer at high temperatures. The HJT solar cell has the higher conversion efficiency and longer service life compared to the conventional N-Type solar cell.

Further, the thickness of the busbar ribbon is 0.05mm to 0.15mm, for example, but not limited to any one point value of 0.05mm, 0.06mm, 0.07mm, 0.08mm, 0.09mm, 0.1mm, 0.11mm, 0.12mm, 0.13mm, 0.14mm, and 0.15mm, or any range value between these two points. The width of the busbar ribbon is 5mm to 15mm, for example, but not limited to any one point value of 5mm, 6mm, 7mm, 8mm, 9mm, 10mm, 11mm, 12mm, 13mm, 14mm, and 15mm, or any range value between these two points. Of course, the busbar ribbons in the entire photovoltaic module can be designed in a thinning and widening method, which can solve the problem of internal cracks of solar cell soldering, and improve the bearing capacity of the solar cell.

Further, the busbar ribbon refers to a metal wire connecting the solar cell, which is usually used to connect the positive and negative electrodes of the solar cell together. In order to improve the efficiency and reduce the cost of solar cell module, the busbar ribbon is usually in a thinning and widening method. Thinning refers to reducing the thickness of the busbar ribbons to reduce the material consumption and cost, and widening refers to increasing the width of the busbar ribbon to improve the current transfer ability. This design can improve the output power and efficiency of the solar cell module, and at the same time reduce the cost. Additionally, the design of thinning and widening of the busbar ribbon can further reduce the resistance of the module and reduce the heat generation. Meanwhile, it can also improve the soldering intensity between the busbar ribbon and the interconnector, and improve the stability of the entire structure after soldering.

Further, the thickness of the busbar ribbon is 0.08 mm to 0.12 mm, for example, but not limited to any one point value of 0.08 mm, 0.09 mm, 0.1 mm, 0.11 mm, and 0.12 mm, or any range value between these two points. The width of the busbar ribbon is 8 mm to 12 mm, for example, but not limited to any one point value of 8 mm, 9 mm, 10 mm, 11 mm, and 12 mm, or any range value between these two points. By further limiting the thickness and width of the busbar ribbon to a more suitable range, it can better take into account the cost of the module, the output power and efficiency of the module, the soldering intensity inside the module, and other properties.

Further, the interconnector 200 is a round wire solder ribbon, and the diameter of the interconnector is 0.15~0.3 mm, for example, but not limited to any one point value of 0.15 mm, 0.17 mm, 0.18 mm, 0.20 mm, 0.22 mm, 0.24 mm, 0.26 mm, 0.28 mm, and 0.3 mm, or any range value between these two points. By limiting the diameter of the interconnector 200 to a specific range, it facilitates soldering to the busbar ribbon with a specific size specification, and at the same time, it can further provide a higher structure intensity for the module after being soldered.

Further, the busbar ribbon and/or interconnector includes a base-material layer located inside and a tin-coated layer coated on the surface of the base-material layer, and a thickness of the tin-coated layer is 10~30 µm. By limiting the thickness of the tin-coated layer to a specific range, the interconnector and the busbar ribbon can be securely soldered together, and it can maintain a lower cost at the same time. The material of the tin-coated layer is not limited, wherein it can be the tin alloy commonly used in the field, such as SnPbBi, SnBiAg, and other alloys.

### Embodiment 2

Based on the embodiment of the present invention above, the embodiment of the present invention provides a photovoltaic device 2000, wherein the photovoltaic device 2000 includes any one of the photovoltaic modules 1000 above. FIG. 9 shows a schematic structure diagram of a photovoltaic device provided by the embodiment of the present invention. The photovoltaic device 2000 usually includes a plurality of photovoltaic modules 1000, and the plurality of photovoltaic modules 1000 form a photovoltaic device 2000 for generating and supplying electricity.

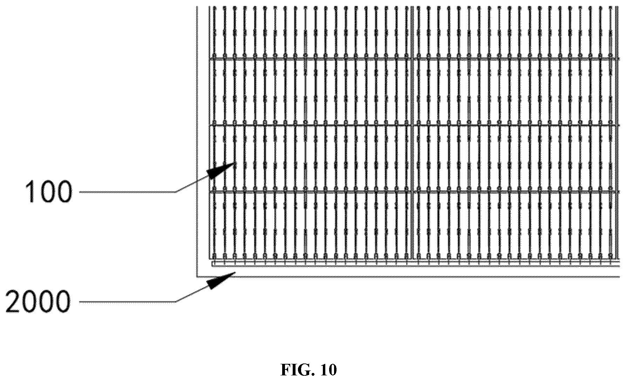

Further, FIG. 10 shows a local schematic structure diagram of a photovoltaic device provided by the embodiment of the present invention. The large-size silicon wafer with the solar cell specification of 182/210 is divided into three solar cell slices by the 1-cut-to-3 design, wherein the number of the busbar is designed as 10~20BB, and it is compatible with solar cells by process such as Perc (passivated emitter and cathode, which is a solar cell process), N-Type (which is a solar cell process), and HJT (high-temperature JET, which is a solar cell process).

The present invention provides a photovoltaic device 2000, including the plurality of photovoltaic modules 1000, wherein the photovoltaic module 1000 includes the interconnector, the busbar ribbon, and the plurality of solar cell strings, wherein the solar cell strings include the plurality of solar cell slices sequentially arranged, and two adjacent solar cell slices are connected by the interconnector; and the plurality of power generation units are formed in the photovoltaic module 1000; the busbar ribbon is arranged on the back side of the photovoltaic module; and the plurality of power generation units are connected in series by electrical connection between the busbar ribbon and the interconnector. It solves problems of the cost, efficiency, and process limitation because the back side of the solar cell is required to directly connect to the busbar ribbon; and at the same time, it further solves the problem of low efficiency due to the soldering of the busbar ribbon and the interconnector in the half-cell module, which improves the efficiency of the module, reduces the costs, broadens the process flow, and improves the user experience.

It is clearly understood by those skilled in the field that for the convenience and brevity of the description, the specific working process of the photovoltaic device described above can refer to the corresponding process in the above embodiments of the photovoltaic module, and will not be repeated herein.

Finally, it should be noted that the above embodiments are only used to illustrate the technical solutions of the present invention, and not to restrict it. Although the present invention is described in detail with reference to the foregoing embodiments, it should not be difficult for a person skill in the art to understand who can still modify the technical solutions recorded in the foregoing embodiments or to make equivalent substitutions for some or all of the technical features therein; and these modification or replacement shall not remove the essence of the corresponding technical scheme from the scope of the technical solutions of each embodiment of the present invention.

## Claims

1. A photovoltaic module, wherein the photovoltaic module comprises: an interconnector, a busbar ribbon, and a plurality of solar cell strings, wherein the solar cell strings comprise a plurality of solar cell slices sequentially arranged, and the two adjacent solar cell slices are connected by the interconnector; and
a plurality of power generation units are formed in the photovoltaic module; the busbar ribbon is arranged on a back side of the photovoltaic module; and the plurality of power generation units are connected in series by electrical connection between the busbar ribbon and the interconnector.

2. The photovoltaic module according to claim 1, wherein the busbar ribbon is a first busbar ribbon; the photovoltaic module further comprises a first diode; the photovoltaic module is provided therein with three power generation units, comprising a first power generation unit, a second power generation unit, and a third power generation unit respectively, wherein
the first diode is connected in parallel to the first power generation unit by the first busbar ribbon.

3. The photovoltaic module according to claim 2, wherein the photovoltaic module further comprises a second busbar ribbon and a second diode, wherein
the second busbar ribbon is arranged on the back side of the photovoltaic module and is connected to the first busbar ribbon, and
the second diode is connected in parallel to the second power generation unit by the second busbar ribbon.

4. The photovoltaic module according to claim 2, wherein the photovoltaic module further comprises a third busbar ribbon and a third diode, wherein
the third busbar ribbon is arranged on the back side of the photovoltaic module and is connected to the first busbar ribbon, and
the third diode is connected in parallel to the third power generation unit by the third busbar ribbon.

5. The photovoltaic module according to claim 1, wherein at least one first solder pad is arranged between the interconnector and the solar cell slices, and the first solder pad connects to the interconnector and the solar cell slices respectively; and
at least one second solder pad is arranged between the interconnector and the busbar ribbon, and the second solder pad connects to the interconnector and the busbar ribbon respectively.

6. The photovoltaic module according to claim 5, wherein the first solder pad forms a first projection on the interconnector; the busbar ribbon forms a second projection on the interconnector; and
the first projection and the second projection are staggered.

7. The photovoltaic module according to claim 5, wherein the number of the second solder pads is 4~20.

8. The photovoltaic module according to claim 1, wherein the solar cell slice is formed by cutting a 182mm silicon wafer into two or three slices; or
the solar cell slice is formed by cutting a 210mm silicon wafer into two or three slices.

9. The photovoltaic module according to claim 1, wherein a thickness of the busbar ribbon is 0.05 mm~0.15 mm.

10. The photovoltaic module according to claim 9, wherein the thickness of the busbar ribbon is 0.08 mm~0.12 mm.

11. The photovoltaic module according to claim 1, wherein a width of the busbar ribbon is 5 mm~15 mm.

12. The photovoltaic module according to claim 11, wherein the width of the busbar ribbon is 8 mm~12 mm.

13. The photovoltaic module according to claim 1, wherein the interconnector is a round wire solder ribbon, and a diameter of the interconnector is 0.15~0.3 mm.

14. The photovoltaic module according to claim 1, wherein the busbar ribbon and/or the interconnector comprises a base-material layer located inside and a tin-coated layer coated on a surface of the base-material layer, and a thickness of the tin-coated layer is 10~30 µm.

15. A photovoltaic device, comprising the photovoltaic module according to any one of claims 1 to 14.
